# EUROPEAN PATENT APPLICATION

(11) **EP 4 361 652 A1**
(43) Date of publication of application: **01.05.2024**
(21) Application number: 22893104.4
(22) Date of filing: 03.11.2022
(51) Int. Cl.: G01R 31/367, G01R 31/36, G01R 31/382, G01R 31/396, G06F 1/3212, G06F 1/3228, G06N 20/00, G06N 3/08, G06N 20/20

(54) **ELECTRONIC DEVICE FOR OBTAINING BATTERY-ASSOCIATED INFORMATION AND METHOD FOR OPERATING SAME**

(30) Priority: 15.11.2021 KR 20210156530; 07.12.2021 KR 20210173831
(71) Applicant: Samsung Electronics Co., Ltd., Suwon-si, Gyeonggi-do 16677 (KR)
(72) Inventor: KWAK, Kwonchon, Suwon-si Gyeonggi-do 16677 (KR)
(74) Representative: Gulde & Partner
(86) International application number: PCT/KR2022/017078
(87) International publication number: WO 2023/085682

(57) **Abstract**

Provided is an electronic device comprising: a battery; a charging circuit connected to the battery; at least one first electronic component connected to the charging circuit; at least one second electronic component connected to the charging circuit and the battery; and a chip set disposed separately from the at least one first electronic component and the at least one second electronic component, connected to the at least one first electronic component and the at least one second electronic component, and including at least one processor, wherein the at least one processor is configured to: run an operating system; receive information associated with the battery from the at least one second electronic component when a state associated with the operating system is a first state; and receive an interrupt configured to terminate execution of the operating system from the at least one second electronic component when the state associated with the operating system is a second state.

## Description

### Technical Field

The disclosure relates to an electronic device for obtaining information related to a battery and a method of operating the same.

### Background Art

Along with the recent rapid development of electronic devices, an electronic device enabling a wireless voice call and information exchange becomes a necessity in daily living. In the early use stage of electronic devices, they were considered simply as portable and wireless call-enabled. As technologies have been developed and wireless Internet was introduced, the electronic devices find their applications in a wider range including games, remote control based on short-range communication, and image capturing through an equipped digital camera beyond simple calls or schedule management, thus satisfying users' demands.

To provide various types of services through an electronic device, the electronic device includes more and more components.

Accordingly, there is a need for implementing a technique of efficiently managing power source (or power) supplied to electronic components.

### Disclosure

### Technical Problem

An electronic device may include an embedded controller (EC) chip implemented to provide various functions. The EC chip may be implemented to provide a function of managing battery-related information (e.g., a battery level (or residual battery capacity) and charging-related information as well as a function of controlling an input device (e.g., a keyboard) and a light generation device (e.g., a light emitting diode (LED)) that are not supported by a processor (e.g., an application processor (AP)) of the electronic device. Accordingly, the processor may be electrically coupled to each of a battery and a charging circuit through the EC chip, and implemented to obtain battery-related information and charging state-related information through the EC chip. However, when the EC chip is mounted in the electronic device, the structure of circuits coupled to the EC chip becomes complicated because the EC chip is implemented to provide various functions in addition to the function of managing battery-related information as described above, thereby increasing the implementation cost and maintenance and repair cost of the electronic device. In addition, to use the functions of the EC chip at an application program level, a program should be separately implemented to obtain information of the EC chip, which may increase the operational burden of the electronic device.

According to various embodiments, an electronic device and a method of operating the same may be implemented to obtain battery-related information and/or charging state-related information without an EC chip, thereby reducing the implementation cost and maintenance and repair cost of the electronic device, and alleviating the operational burden of the electronic device.

Further, according to various embodiments, an electronic device and a method of operating the same may be implemented to obtain battery-related information through an electronic component always placed in a turned-on state, so that even when an operating system running in the electronic device may safely turn off the electronic device based on battery-related information obtained even in a sleep state, thereby increasing the use stability of the electronic device.

### Technical Solution

According to various embodiments, an electronic device may include a battery, a charging circuit coupled to the battery, at least one first electronic component coupled to the charging circuit, at least one second electronic component coupled to the charging circuit and the battery, and a chipset disposed separately from the at least one first electronic component and the at least one second electronic component, coupled to the at least one first electronic component and the at least one second electronic component, and including at least one processor. The at least one processor may be configured to execute an operating system, when an operating system-related state is a first state, receive battery-related information from the at least one second electronic component, and when the operating system-related state is a second state, receive an interrupt configured to terminate execution of the operating system from the at least one second electronic component.

According to various embodiments, a method of operating an electronic device may include executing an operating system, when an operating system-related state is a first state, receiving battery-related information from at least one second electronic component coupled to a charging circuit of the electronic device and a battery of the electronic device, and when the operating system-related state is a second state, receiving an interrupt configured to terminate the execution of the operating system from the at least one second electronic component.

According to various embodiments, an electronic device may include a battery, a charging circuit coupled to the battery, at least one electronic component coupled to the charging circuit, an input device coupled to the charging circuit and the battery, and a chipset disposed separately from the at least one electronic component and the input device, coupled to the at least one electronic component and the input device, and including at least one processor. The input device may be configured to, when a level of the battery is higher than a first level, transmit the battery-related information to the at least one processor, and when the level of the battery is equal to or lower than the first level, transmit an interrupt configured to terminate execution of an operating system to the at least one processor.

The technical solutions according to various embodiments are not limited to the above-described ones, and those skilled in the art will clearly understand technical solutions which have not been described from the specification and the accompanying drawings.

### Advantageous Effects

According to various embodiments, an electronic device and a method of operating the same may be provided, in which a processor obtains battery-related information and/or charging state-related information without an embedded controller (EC) chip, thereby reducing the implementation cost and maintenance and repair cost of the electronic device, and alleviating the operational burden of the electronic device.

Further, according to various embodiments, an electronic device and a method of operating the same may be provided, which obtain battery-related information through an electronic component always placed in a turned-on state, so that even when an operating system running in the electronic device may safely turn off the electronic device based on battery-related information obtained even in a sleep state, thereby increasing the use stability of the electronic device.

### Description Of The Drawings

FIG. 1 is a block diagram illustrating an electronic device in a network environment according to various embodiments.
FIG. 2 is a diagram illustrating an exemplary electronic device according to various embodiments.
FIG. 3 is a diagram illustrating an exemplary electronic device according to various embodiments.
FIG. 4A is a diagram illustrating an exemplary connection relationship between electronic components to obtain power information about an electronic device according to various embodiments.
FIG. 4B is a diagram illustrating an exemplary operation of a module (or a program or computer code) to obtain power information about an electronic device according to various embodiments.
FIG. 4C is a diagram illustrating an example of software and hardware in an electronic device according to various embodiments.
FIG. 5A is a diagram illustrating an exemplary module (or program or computer code) to obtain power information about an electronic device according to various embodiments.
FIG. 5B is a diagram illustrating another exemplary module (or program or computer code) to obtain power information about an electronic device according to various embodiments.
FIG. 6 is a flowchart illustrating an exemplary operation of an electronic device (e.g., a processor) according to various embodiments.
FIG. 7 is a flowchart illustrating an exemplary operation of an electronic device (e.g., a processor) according to various embodiments.
FIG. 8A is a diagram illustrating an exemplary operation of an electronic device, while an operating system is in a first state according to various embodiments.
FIG. 8B is a diagram illustrating an exemplary operation of an electronic device, while an operating system is in a second state according to various embodiments.
FIG. 9 is a flowchart illustrating an exemplary operation of an electronic device (e.g., a processor) according to various embodiments.
FIG. 10 is a flowchart illustrating an exemplary operation of a second electronic component (e.g., a processor) according to various embodiments.

### Mode For Invention

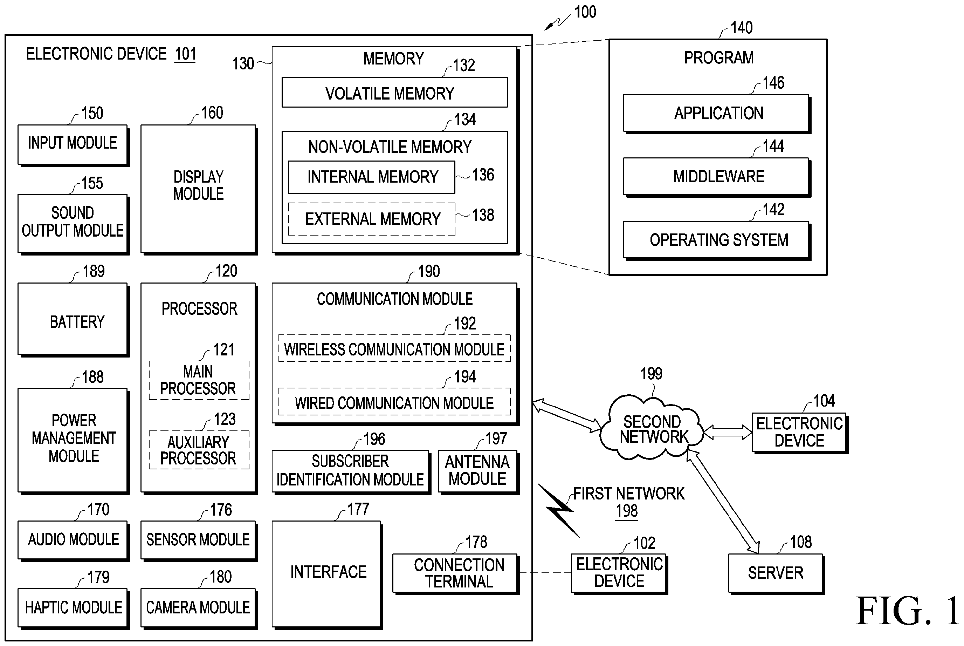

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) (e.g., a speaker or headphone) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102).According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", or "connected to" another element (e.g., a second element), it means that the element may be coupled with the other element directly (e.g., wired), wirelessly, or via a third element.

As used in connection with various embodiments of the disclosure, the term "module" may include a unit implemented in hardware, software, or firmware, and may interchangeably be used with other terms, for example, logic, logic block, part, or circuitry. A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., a program 140) including one or more instructions that are stored in a storage medium (e.g., internal memory 136 or external memory 138) that is readable by a machine (e.g., an electronic device 101). For example, a processor (e.g., a processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semipermanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

A description will be given of various embodiments of an electronic device 200 (e.g., the electronic device 101 of FIG. 1) according to the disclosure.

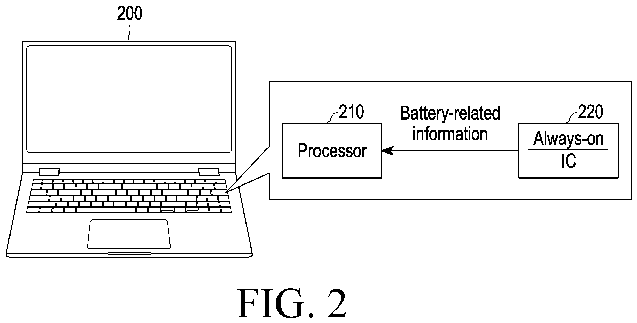

FIG. 2 is a diagram illustrating an example of the electronic device 200 according to various embodiments.

According to various embodiments, the electronic device 200 (e.g., a processor 210) may obtain information for controlling (or managing) power of the electronic device 200 from a specific integrated circuit (IC) 220 (or a specific electronic component) among a plurality of ICs provided in the electronic device 200, as illustrated in FIG. 2. The specific IC 220 may be an IC kept (continuously) in a turned-on (or always-on) state in the electronic device 200. Always-on means that when the battery level of the electronic device 200 and/or a state related to an OS running in the electronic device 200 is changed, power is supplied to the specific circuit so that the specific circuit is kept in the turned-on state. For example, when the electronic device 200 is changed (or lowered) from a battery level higher than a specific level to a battery level equal to or lower than the specific level, and/or when a state related to the OS of the electronic device 200 is changed (or set) from one state to another specific state, the specific IC 220 may be maintained in the turned-on state. The specific IC 220 maintained in the turned-on state may be determined according to a policy of the OS running in the electronic device 200. For example, in the case where an input device should be maintained in the turned-on state to receive a user input (e.g., contact, voice, or touch) for waking up the electronic device 200 in a sleep state of the electronic device according to the policy of the OS, an input device IC for controlling the input device may be an IC (e.g., always-on IC) maintained in the turned-on state. While the specific IC 220 always maintained in the turned-on state has been described as the input device IC, by way of example, the specific IC 220 may be implemented as various types of electronic components, not limited to the input device IC. For example, the specific IC 220 may include a communication device IC (e.g., an RF-IC, a communication processor, and various types of communication circuits) and an output device IC, in addition to the input device IC. The output device IC may include an audio device IC (e.g., a digital signal processing (DSP) circuit) for controlling an audio device (e.g., a speaker). The output device IC may include an IC for controlling a device for outputting a plurality of types of content (e.g., visual, auditory, and tactile content), not limited to the audio device IC.

For example, the battery level may indicate a remaining battery capacity, and the specific level of the battery may be a battery level set to turn off the electronic device 200. For example, the specific level of the battery may be 3%.

For example, the state related to the OS may include a power management state, and at least some of the electronic components of the electronic device 200 may be configured to receive power according to the power management state. For example, the power management state may include a first power state in which the processor 210 operates to supply power to all of the plurality of electronic components (e.g., by controlling a charging circuit to be described later), a second power state in which the processor 210 operates to supply power to some (e.g., the processor 210 and memory) of the plurality of electronic components, and a third power state in which the processor 210 operates to supply power only to a specific electronic component (e.g., the specific IC 220) among the plurality of electronic components. The specific state may refer to the third power state. For example, the power management state may include power saving modes defined by Microsoft (MS), and the third power state may mean a deep sleep mode.

According to various embodiments, the above-described power information may include battery-related information, an interrupt (or signal) configured to turn off the electronic device 200, and charging circuit-related information. For example, the battery-related information may include information about at least one of a capacity of the battery, a current of the battery, a temperature of the battery, a level of the battery (or a remaining capacity of the battery), a charging time of the battery, or the number of times the battery has been charged and/or discharged. For example, the charging circuit-related information may include information related to a charging state of the battery. For example, the information related to the charging state of the battery may include at least one of a temperature of the battery, power (e.g., voltage and current) of the battery, or a time taken to fully charge the battery during charging of the battery.

According to various embodiments, the electronic device 200 (e.g., the processor 210) may perform at least one operation based on power information received through the specific IC 220. For example, the processor 210 may transmit the battery-related information and/or the battery charging state-related information to at least one program, so that the program provides a function based on the obtained information. Further, for example, the processor 210 may terminate the OS and turn off the electronic device 200 based on reception of the interrupt.

Various embodiments of the electronic device 200 (e.g., the electronic device 101 of FIG. 1) according to the disclosure will be described below.

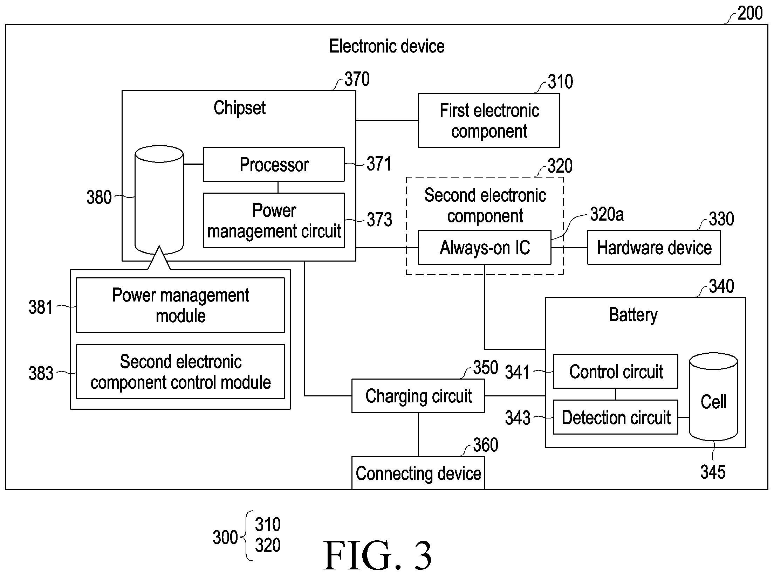

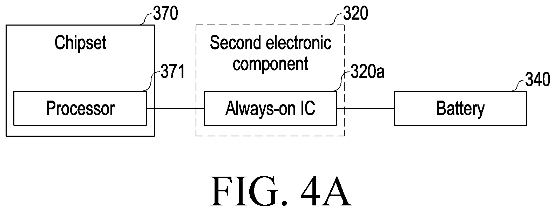

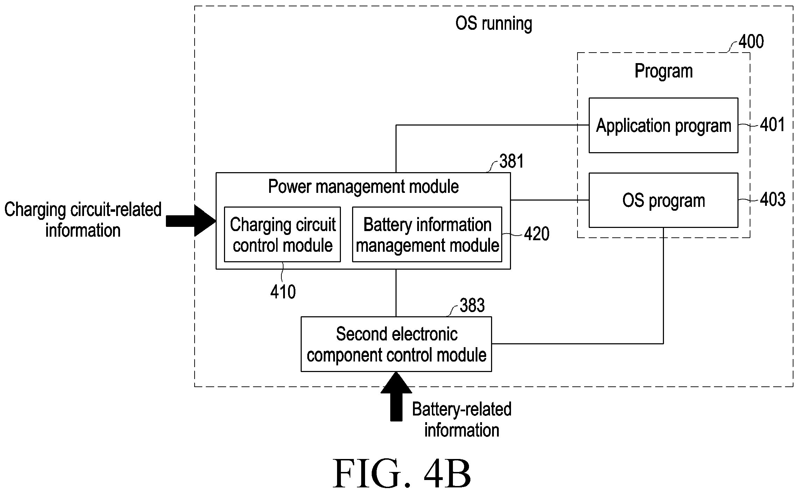

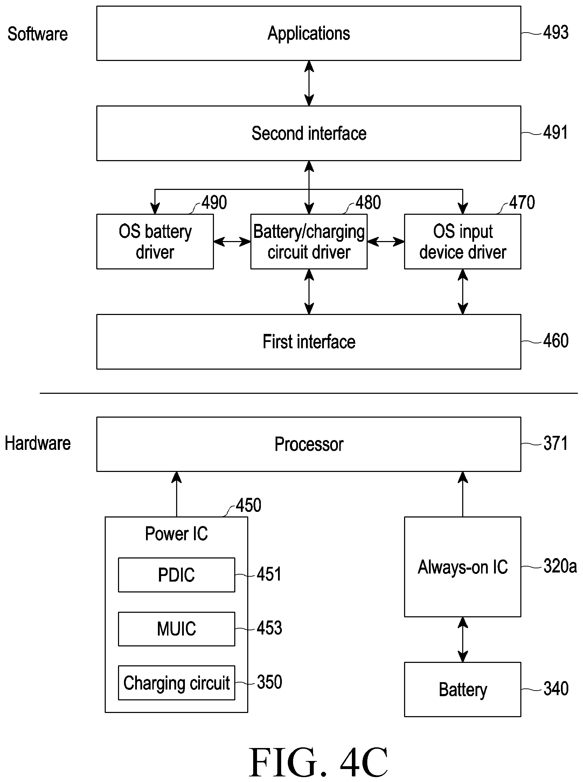

FIG. 3 is a diagram illustrating an example of the electronic device 200 according to various embodiments. FIG. 3 will be described with reference to FIGS. 4A, 4B and 4C.

FIG. 4A is a diagram illustrating an exemplary connection relationship between electronic components to obtain power information about the electronic device 200 according to various embodiments. FIG. 4B is a diagram illustrating an exemplary operation of a module (or a program or computer code) to obtain power information about the electronic device 200 according to various embodiments. FIG. 4C is a diagram illustrating an example of software and hardware in the electronic device 200 according to various embodiments.

According to various embodiments of the disclosure, referring to FIG. 3, the electronic device 200 may include a plurality of electronic components 300 including a first electronic component 310 and a second electronic component 320, a hardware device 330, a battery 340, a charging circuit 350, a connecting device 360, and a chipset 370 including a processor 371, a power management circuit 373, and memory 380. The hardware device 330, the battery 340, the charging circuit 350, the connecting device 360, the processor 371, and the memory 380 may be understood as electronic components, and the term electronic component may be understood as IC or device. The electronic device 200 may be implemented to include additional electronic components or not to include some of the described and/or illustrated electronic components, not limited to the description and/or the illustration of FIG. 3. The memory 380 may be implemented separately from the chipset 370.

Referring to FIG. 3 illustrating electrical connection relationships among electronic components according to various embodiments, the chipset 370 may be electrically coupled to the first electronic component 310, the second electronic component 320, and the charging circuit 350. The second electronic component 320 may be electrically coupled to the battery 340. The electrical coupling may be established (or set up) through a predetermined communication interface mounted in the electronic device 200. The communication interface may include an Inter integrated circuit (I2C) and a system management bus (SMBUS). Among the plurality of electronic components 300, the second electronic component 320 may include an always-on electronic component (e.g., the always-on IC of FIG. 2), and the first electronic component 310 may include the other electronic components except for the second electronic component 320. For example, the plurality of electronic components may include the display module 160, the sound output module 155, the communication module 190, the sensor module 176, and so on described with reference to FIG. 1, and the second electronic component 320 may include an always-on IC 320a including always-on electronic components described with reference to FIG. 2.

According to various embodiments, the always-on IC 320a may be a control circuit to control the hardware device 330. In an embodiment, the always-on IC 320a may be an input device IC to control an input device, and the hardware device 330 may be an input device including a keyboard, a microphone, a touch screen, and a camera. The hardware device 330 may further include various types of input devices to obtain a user input (e.g., contact, voice, and touch), not limited to the described examples. The always-on IC 320a may be implemented to obtain electrical information (e.g., current and/or voltage) generated by a user input received in the hardware device 330, process (e.g., digitize) the obtained electrical information, and transmit the processed information to the processor 371. In another embodiment, the always-on IC 320a may be a communication device IC (e.g., an RF-IC, a communication processor, and various types of communication circuits) or an output device IC, in addition to the input device IC, as described before with reference to FIG. 2, not limited to the description. The hardware device 330 may be a communication device (e.g., an antenna) or an output device (e.g., a speaker).

According to various embodiments, the always-on IC 320a may include an electronic component of a type determined to be maintained in the turned-on state according to the policy of an OS running in the electronic device 200. For example, when an input device should be maintained in the turned-on state to receive a user input (e.g., contact, voice, or touch) for waking up the electronic device 200 in a sleep state, while the electronic device 200 is in the sleep state according to the policy of the OS, an input device IC for controlling the input device may be an IC (e.g., always-on IC) maintained in the turned-on state. Accordingly, when obtaining electrical information (e.g., current and/or voltage) generated by a user input received by the hardware device 330, the always-on IC 320a may transmit an interrupt for wake-up to the processor 371. As described above, the always-on IC 320a may include other types of electronic components other than the input device IC according to the policy of the OS.

According to various embodiments, referring to FIG. 4A, the processor 371 may be electrically coupled to the battery 340 through the second electronic component 320 (e.g., the always-on IC 320a). In an embodiment, the second electronic component 320 (e.g., the always-on IC 320a) may obtain battery-related information from the battery 340 and transmit the battery-related information to the processor 371. In another embodiment, the second electronic component 320 (e.g., the always-on IC 320a) may obtain the battery-related information from the battery 340, and based on identifying the level of the battery 340, transmit an interrupt for turning off the electronic device 200 to the processor 371.

According to various embodiments, the battery 340 (or a battery pack or a battery module) may be implemented to charge (or accumulate) and discharge (or supply) power (e.g., current and/or voltage). For example, power may be accumulated by a cell 345 included in the battery 340. The cell 345 is a component of a basic unit of the battery 340 capable of charging and/or discharging electrical energy, and may be implemented to include an anode, a cathode, a separator, and/or an electrolyte. A plurality of cells 345 may be provided, arranged in the battery 340, and electrically coupled to each other (e.g., in parallel and/or in series). Power may be discharged from the cell 345 to other electronic components (e.g., the first electronic component 310 and the second electronic component 320) of the electronic device 200.

According to various embodiments, the battery 340 may be implemented to obtain the battery-related information. For example, a control circuit 341 of the battery 340 may obtain the battery-related information using a detection circuit 343. The detection circuit 343 may include a power (e.g., voltage and/or current) detection circuit and a temperature detection circuit. The battery 340 may transmit the battery-related information to the second electronic component 320 (e.g., the always-on IC 320a) coupled to the battery 340.

According to various embodiments, the charging circuit 350 may be implemented to obtain external power from the connecting device 360 to charge the battery 340. For example, the connecting device 360 may include a connecting terminal for coupling to an external power supply. As will be described later, when a charging connection is identified through the connecting device 360, the processor 371 may charge the battery 340 using the charging circuit 350 based on external power received through the connecting device 360. In addition to the charging circuit 350, the electronic device 200 may further include various types of circuits (e.g., the power IC 450) for transmitting/receiving (obtaining/supplying) power, such as a power delivery integrated chip (PDIC) 451, a micro-USB interface controller (MUIC) 453, and a cable and connector integrated chip (CCIC) (not shown), as illustrated in FIG. 4C.

According to various embodiments, the chipset 370 may be implemented separately from the afore-described electronic components (e.g., the plurality of electronic components 300, the battery 340, and the charging circuit 350), include the processor 371, the power management circuit 373, and the memory 380, and further include circuits for providing various types of functions, not limited to the description and/or the illustration. The power management circuit 373 may include a power management integrated circuit (PMIC). The processor 371 may use the power management circuit 373 to control the power supplied to each electronic component to be described later. As described before, the memory 380 may be provided outside the chipset 370.

According to various embodiments, the processor 371 included in the chipset 370 may include at least one of an application processor (AP), a central processing unit (CPU), a graphic processing unit (GPU), a display processing unit (DPU), or a neural network (NPU). The processor 371 may be implemented (or configured or constructed) to control electronic components (e.g., the first electronic component 310, the second electronic component 320, and the charging circuit 350) coupled to the chipset 370. The processor 371 may perform an operation of managing power of the electronic device 200 using the power management circuit 373 implemented in the chipset 370. The power management circuit 373 may include a PMIC.

Operations of modules described below may be understood as operations of the processor 371 performed according to execution of the modules (e.g., a power management module 381 and a second electronic component control module 383) stored in the memory 380. At least some of the modules (e.g., the power management module 381 and the second electronic component control module 383) stored in the memory 380 may be implemented (e.g., executed) in software, firmware, or a combination of at least two thereof. For example, the modules may be implemented in the form of an application, a program, computer code, instructions, a routine, or a process, which is executable by the processor 371. Accordingly, when the modules (e.g., the power management module 381 and the second electronic component control module 383) are executed by the processor 371, the modules (e.g., the power management module 381 and the second electronic component control module 383) may cause the processor 371 to perform an operation related to the modules (or a function that the modules may provide). Therefore, when it is said below that a specific module performs an operation, this may be interpreted as the processor 371 performing the operation according to execution of the specific module. Alternatively, the modules (e.g., the power management module 381 and the second electronic component control module 383) may be implemented as part of a specific application. Alternatively, each module may be implemented as hardware (e.g., a processor or a control circuit) separate from the processor 371, not limited to the description and/or the illustration. At least some of the operations of the modules described below may be implemented as a separate module other than the modules.

An example of software components of the electronic device 200 will be described with reference to FIGS. 4B and 4C.

According to various embodiments, the power management module 381 may be implemented to transmit (or deliver) and/or receive (or obtain) a plurality of programs and information. Referring to FIG. 4B, a plurality of programs 400 may include an OS program 403, an application program 401, and a driver (not shown). For example, the power management module 381 may obtain (e.g., read) information from or transmit (e.g., write) information to the plurality of programs 400 using at least one function (e.g., an application programming interface (API)). Further, the power management module 381 may notify the plurality of programs 400 of information, using at least one function (e.g., API). The OS program 403 may include programs implemented in a kernel and/or a driver for power management.

According to various embodiments, the power management module 381 (e.g., a battery information management module 420) may obtain power information, and transmit (or provide) at least part of the obtained power information to a program (or application) running in the electronic device 200. For example, the power management module 381 may obtain battery-related information from the second electronic component control module 383 and transmit the obtained battery-related information to other programs (e.g., the OS program 403 and the application program 401), as illustrated in FIG. 4B. As described above, the battery-related information may include information about at least one of the capacity of the battery 340, the current of the battery 340, the temperature of the battery 340, the level of the battery 340 (or the remaining capacity of the battery 340), a charging time of the battery 340, or the number of times the battery 340 has been charged and/or discharged.

According to various embodiments, the power management module 381 (e.g., a charging circuit control module 410) may be implemented to transmit a signal for controlling the charging circuit 350 to the charging circuit 350 and/or obtain information from the charging circuit 350. For example, at least part of the power management module 381 may be a driver for the charging circuit 350 supported (or provided) by the OS. For example, the power management module 381 may obtain charging circuit-related information from the charging circuit 350 and transmit the charging circuit-related information to other programs (e.g., the OS program 403 and the application program 401), as illustrated in FIG. 4B. As described above, the charging circuit-related information may include charging state-related information, and include information about at least one of the temperature of the battery, the power (e.g., voltage and current) of the battery, or a time taken to fully charge the battery.

According to various embodiments, the second electronic component control module 383 may transmit a signal for controlling the second electronic component 320 (e.g., the always-on IC 320a) to the second electronic component 320 and/or obtain information from the second electronic component 320 (e.g., the always-on IC 320a). For example, as illustrated in FIG. 4C, the second electronic component control module 383 may be a driver for the second electronic component 320 (e.g., the always-on IC 320a) supported by the OS. While the second electronic component control module 383 is described as an OS input device driver 470 in the context of the always-on IC 320a being an input device IC, by way of example, when the always-on IC 320a is a different type of IC, the second electronic component control module 383 may be implemented as a driver for controlling the corresponding IC, not limited to the described example. For example, the second electronic component control module 383 may obtain power information from the always-on IC 320a, as illustrated in FIG. 4B. For example, the second electronic component control module 383 may obtain battery-related information. The second electronic component control module 383 may transmit the obtained battery-related information to the power management module 381. Alternatively, the power management module 381 may obtain the battery-related information from the second electronic component control module 383. In another example, the second electronic component control module 383 may receive an interrupt configured to terminate the OS and/or the electronic device 200 from the always-on IC 320a. The second electronic component control module 383 may transmit the interrupt to the OS program 403. The OS program 403 may include a power management program (e.g., a driver) provided (or supported) by the OS. The OS program 403 may terminate the OS and the electronic device 200 based on the interrupt.

The above-described power management module 381 and the second electronic component control module 383 may receive information (e.g., power information) from a hardware device based on a specific program (e.g., firmware). For example, referring to FIG. 4C illustrating a specific example of software and hardware of the electronic device 200, a battery/charging circuit driver 480 (e.g., the power management module 381) and the OS input device driver 470 (e.g., the second electronic component control module 383) may receive information (e.g., battery-related information) through each hardware IC based on a first interface 460 (or firmware) supported by the OS. For example, the first interface 460 may include an advanced configuration and power interface (ACPI). Referring also to FIG. 4C, the battery/charging circuit driver 480 (e.g., the power management module 381) may provide information (e.g., battery-related information) to a battery driver 490 (or the power management program) supported by the OS, or transmit the information (e.g., battery-related information) to the application 401 (e.g., applications 493) based on a second interface 491 (or firmware) supported by the OS. As described later, the OS input device driver 470 (e.g., the second electronic component control module 383) may directly transmit an interrupt configured to terminate the OS to the battery driver 490 (or the power management program).

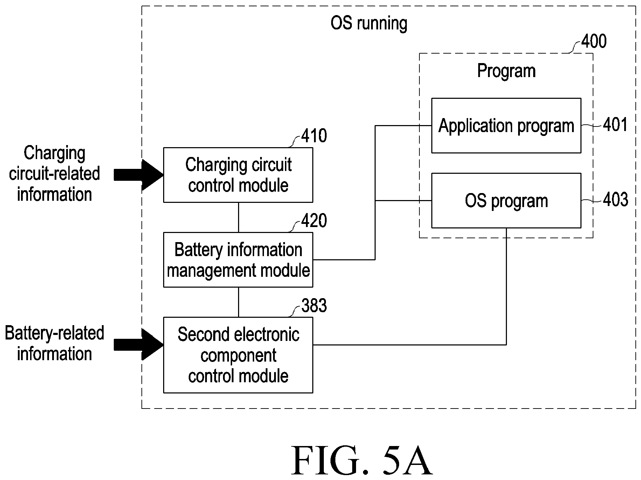

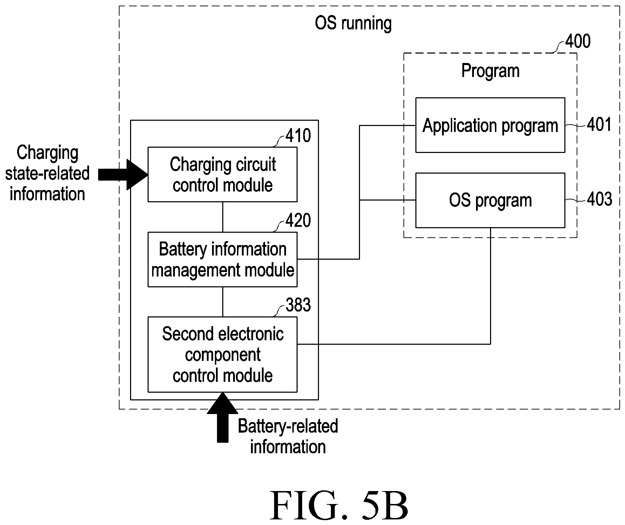

Another example of the software components of the electronic device 200 will be described with reference to FIGS. 5A and 5B.

FIG. 5A is a diagram illustrating an exemplary module (or program or computer code) for obtaining power information about the electronic device 200 according to various embodiments. FIG. 5B is a diagram illustrating another exemplary module (or program or computer code) for obtaining power information about the electronic device 200 according to various embodiments.

According to various embodiments, referring to FIG. 5A, compared to FIG. 4B, each of the charging circuit control module 410 and the battery information management module 420 included in the afore-described power management module 381 may be implemented separately. In this case, the battery information management module 420 may obtain charging state-related information from the charging circuit control module 410 using at least one function (e.g., API), and battery-related information from the second electronic component control module 383. The battery information management module 420 may transmit the obtained information to other programs (e.g., the OS program 403 and the application program 401).

According to various embodiments, referring to FIG. 5B, compared to FIG. 4B, the second electronic component control module 383 may be further implemented in the afore-described power management module 381. Accordingly, the power management module 381 may perform a function for the above-described second electronic component control module 383.

An exemplary operation of the electronic device 200 according to various embodiments will be described below.

According to various embodiments, the processor 371 may obtain battery-related information through an always-on electronic component among a plurality of electronic components, and provide the battery-related information (e.g., to a program running in the electronic device 200).

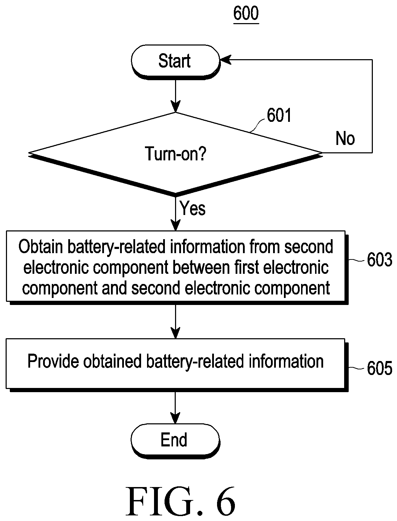

FIG. 6 is a flowchart 600 illustrating an exemplary operation of the electronic device 200 (e.g., the processor 371) according to various embodiments. According to various embodiments, the operations illustrated in FIG. 6 may be performed in various orders, not limited to the illustrated order. Further, according to various embodiments, more operations than those illustrated in FIG. 6 or at least one operation fewer than those illustrated in FIG. 6 may be performed.

According to various embodiments, the electronic device 200 (e.g., the processor 371) may determine whether the electronic device 200 has been turned on in operation 601. For example, when a hardware key for turning on the electronic device 200 is pressed in the electronic device 200, power may be supplied to electronic components of the electronic device 200. The afore-described power management module 381 may identify the turned-on state of the electronic device 200 and perform operations 603 and 605 based on the identification, not limited to the description.

According to various embodiments, when the electronic device 200 has been turned on (operation 601-Yes), the electronic device 200 (e.g., the processor 371) may obtain battery-related information from the second electronic component 320 between the first electronic component 310 and the second electronic component in operation 603. For example, the electronic device 200 (e.g., the processor 371) may obtain battery-related information obtained by the second electronic component 320 (e.g., the always-on IC 320a) among a plurality of electronic components (e.g., the first electronic component 310 and the second electronic component 320). As described before, the second electronic component 320 may be defined as an electronic component always maintained in the turned-on state. For example, the second electronic component 320 may be electrically coupled to the battery 340 and obtain the battery-related information from the battery 340. The processor 371 may be electrically coupled to the second electronic component 320 and obtain the battery-related information from the second electronic component 320. The battery-related information may include information about at least one of the capacity of the battery 340, the current of the battery 340, the temperature of the battery 340, the level of the battery 340 (or the remaining capacity of the battery 340), a charging time of the battery 340, or the number of times the battery 340 has been charged and/or discharged. The operation of obtaining battery-related information by the processor 371 may be performed by the operation of the power management module 381 and the second electronic component control module 383 described above, and a redundant description will be avoided.

According to various embodiments, the electronic device 200 (e.g., the processor 371) may provide the battery-related information from the second electronic component 320 between the first electronic component 310 and the second electronic component 320 in operation 605. For example, the processor 371 may provide the battery-related information to a currently running program (e.g., the application program 401 or the OS program 403). Upon receipt of the battery-related information, the program may perform at least one function based on the battery-related information.

An exemplary operation of the electronic device 200 according to various embodiments will be described below.

According to various embodiments, the electronic device 200 (e.g., the processor 371) may obtain battery-related information or receive an interrupt for terminating the OS and/or turning off the electronic device 200 through an always-on electronic component among a plurality of electronic components according to the state of the OS.

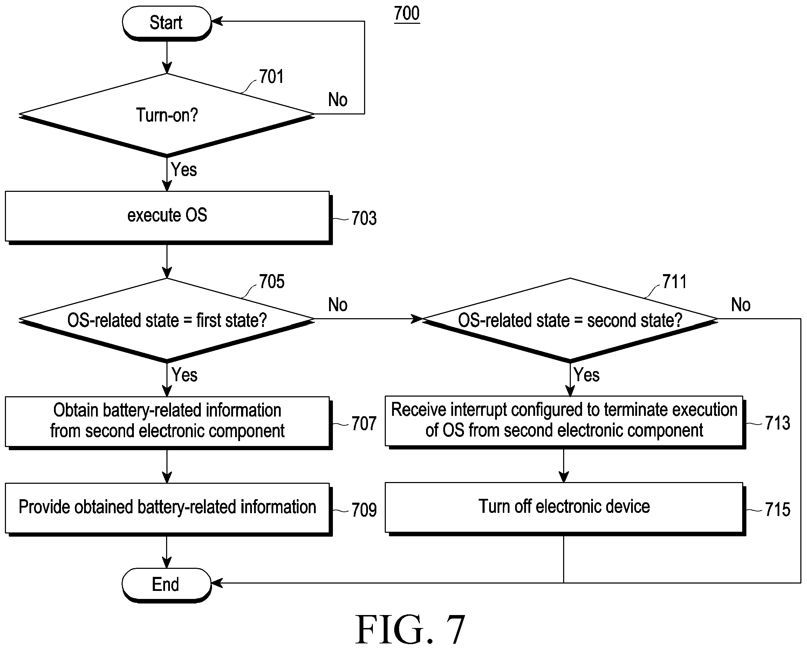

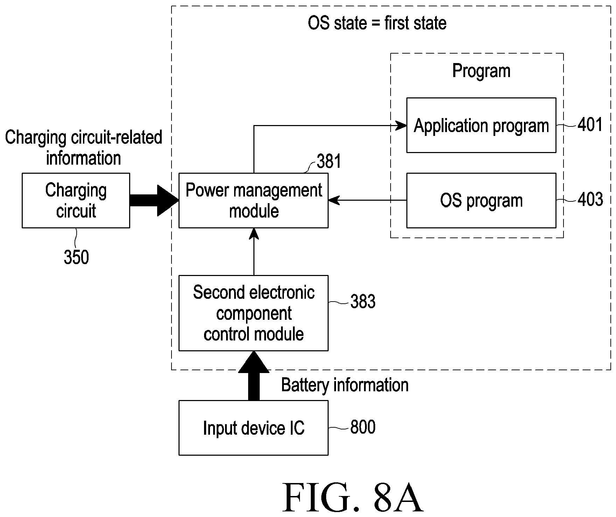

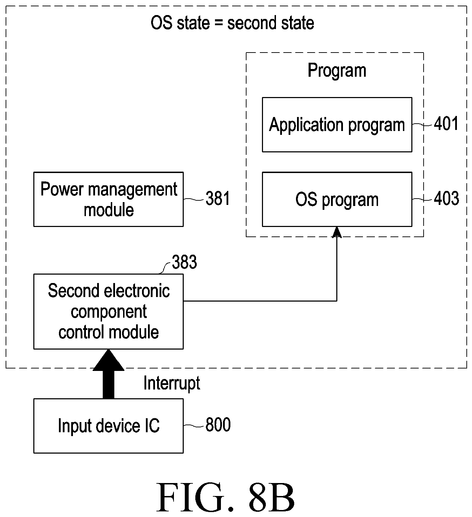

FIG. 7 is a flowchart 700 illustrating an exemplary operation of the electronic device 200 (e.g., the processor 371) according to various embodiments. According to various embodiments, the operations illustrated in FIG. 7 may be performed in various orders, not limited to the illustrated order. Further, according to various embodiments, more operations than those illustrated in FIG. 7 or at least one operation fewer than those illustrated in FIG. 7 may be performed. FIG. 7 will be described with reference to FIGS. 8A and 8B.

FIG. 8A is a diagram illustrating an exemplary operation of the electronic device 200, while the OS is in a first state according to various embodiments. FIG. 8B is a diagram illustrating an exemplary operation of the electronic device 200, while the OS is in a second state according to various embodiments.

According to various embodiments, the electronic device 200 (e.g., the processor 371) may determine whether the electronic device 200 has been turned on in operation 701. For example, when a hardware key of the electronic device 200 for turning on the electronic device 200 is pressed, the turn-on of the electronic device 200 may be identified. Further, for example, the electronic device 200 may identify its turn-on based on reception of an interrupt from an electronic component (e.g., a timer device) implemented to provide the interrupt for turning on the electronic device 200. For example, the timer device may be implemented to calculate time even when the electronic device 200 is in a turned-off state and/or an inactive state, and when the calculated time reaches a specific time, generate the interrupt for turning on the electronic device, and may include, for example, a real time clock (RTC) device (or module). When identifying its turn-on, the electronic device 200 may supply power to electronic components of the electronic device 200.

According to various embodiments, the electronic device 200 (e.g., the processor 371) may execute the OS in operation 703. For example, based on the execution of the OS stored in the memory 380, the electronic device 200 may execute a program supported by the OS and at least one other application program 401 installed in the electronic device 200. The program supported by the OS may include the afore-described application program and modules (e.g., the power management module 381 and the second electronic component control module 383).

According to various embodiments, the electronic device 200 (e.g., the processor 371) may identify at least some electronic components to which power is to be supplied among the plurality of electronic components included in the electronic device 200, based on an OS-related state. For example, the OS-related state may include a first power state set for the electronic device 200 (e.g., the processor 371) to supply power to all of the plurality of electronic components, a second power state set for the processor 371 to supply power to some (e.g., the processor 371 and the memory 380) of the plurality of electronic components, and a third power state set for the processor 371 to supply power only to a specific electronic component (e.g., the second electronic component 320). For example, the third power state may include a deep sleep state.

According to various embodiments, in operation 705, the electronic device 200 (e.g., the processor 371) may determine whether the OS is in the first state (or whether the OS corresponds to the first state). When the OS is in the first state (operation 705-Yes), the electronic device 200 (e.g., the processor 371) may obtain battery-related information from the second electronic component 320 in operation 707, and provide the obtained battery-related information in operation 709. For example, the remaining power states other than the above-described third power state may be defined as a normal state (e.g., the first state). While the OS is in the first state, the electronic device 200 may perform operations 603 and 605 described above. For example, as illustrated in FIG. 8A, the electronic device 200 (e.g., the power management module 381) may successfully obtain battery-related information obtained by the second electronic component 320 and provide the battery-related information to programs (e.g., the OS program 403 and the application program 401) to perform normal operations.

According to various embodiments, when the OS is not in the first state (or the OS does not correspond to the first state) (operation 705-No), the electronic device 200 (e.g., the processor 371) may determine whether the OS is in the second state (or whether the OS corresponds to the second state) in operation 711. When the OS is in the second state (operation 711-Yes), the electronic device 200 (e.g., the processor 371) may receive an interrupt configured to terminate the execution of the OS from the second electronic component 320 in operation 713, and may be turned off in operation 715. For example, the third power state (e.g., the deep sleep state) of the OS may be defined as an abnormal state (e.g., the second state). While the OS is in the second state, the electronic device 200 may maintain only the second electronic component 320 (e.g., an input device IC 800) in the turned-on state among the plurality of electronic components. For example, the second electronic component 320 (e.g., the input device IC 800) may be maintained in the turned-on state based on reception of power from the directly coupled battery 340. When the level of the battery 340 is lower than or equal to a specific level while the OS is in the second state, the processor 371 may terminate the execution of the OS and turn off the electronic device 200 based on an interrupt for turning off the electronic device, received from the second electronic component 320 (e.g., the input device IC 800).

For example, as illustrated in FIG. 8B, the second electronic component 320 (e.g., the input device IC 800) may identify the level of the battery 340 every specified period based on battery-related information received from the battery 340. The second electronic component 320 may determine whether the identified level of the battery 340 is equal to or lower than a specific level, and when the identified level of the battery 340 is equal to or lower than the specific level, transmit an interrupt to the processor 371. That is, when the OS is in the second state and the level of the battery 340 is equal to or lower than the specific level, the second electronic component control module 383 of the processor 371 may obtain an interrupt and transmit the obtained interrupt to the OS. The OS program (e.g., a power management driver) may perform a function of terminating the execution of the OS and turning off the electronic device 200 in response to the reception of the interrupt.

According to various embodiments, when the OS is in the second state and the level of the battery 340 is higher than the specific level, the electronic device 200 (e.g., the processor 371) may receive an interrupt for wake-up. For example, when the second electronic component 320 (e.g., the input device IC 800) obtains electrical information by a user input to the input device 330 while the level of the battery 340 is higher than the specific level, the second electronic component 320 may transmit the interrupt for wake-up to the processor 371. The processor 371 may change the state of the OS from the second state to the first state based on the reception of the interrupt.

While it has been described that the second electronic component 320 is the input device IC 800 by way of example, the second electronic component 320 may be implemented as a communication device IC or an output device IC as described before with reference to FIGS. 2 to 4B, not limited to the described example.

An exemplary operation of the electronic device 200 according to various embodiments will be described below.

According to various embodiments, the electronic device 200 (e.g., the processor 371) may receive information (e.g., battery-related information) through the afore-described second electronic component 320 and/or perform at least one charging operation based on the charging circuit 350, depending on whether a charging connection has been established through the connecting device 360.

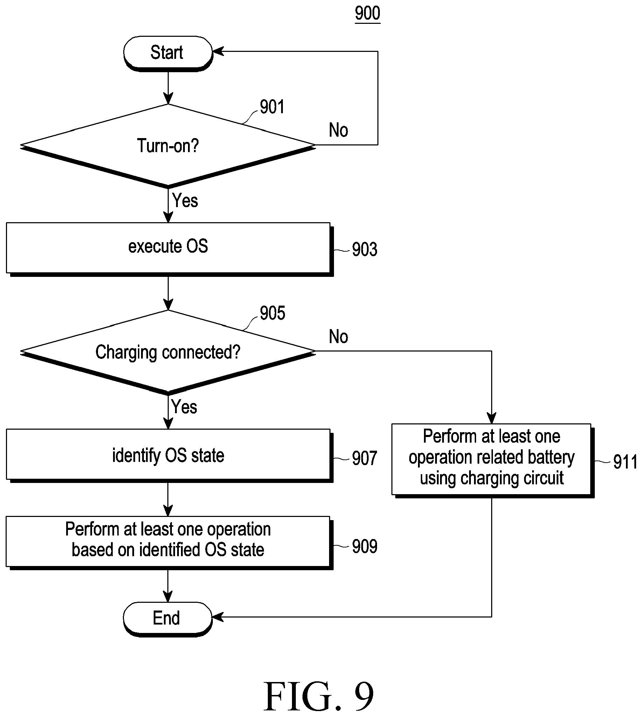

FIG. 9 is a flowchart 900 illustrating an exemplary operation of the electronic device 200 (e.g., the processor 371) according to various embodiments. According to various embodiments, the operations illustrated in FIG. 9 may be performed in various orders, not limited to the illustrated order. Further, according to various embodiments, more operations than those illustrated in FIG. 9 or at least one operation fewer than those illustrated in FIG. 9 may be performed.

According to various embodiments, the electronic device 200 (e.g., the processor 371) may determine whether the electronic device 200 has been turned on in operation 901. For example, when a hardware key of the electronic device 200 for turning on the electronic device 200 is pressed, power may be supplied to a plurality of electronic components of the electronic device 200.

According to various embodiments, the electronic device 200 (e.g., the processor 371) may execute the OS in operation 903. For example, the electronic device 200 may execute the OS stored in the memory 380 based on its turn-on. The electronic device 200 may execute a program supported by the executed OS and other application programs 401 installed in the electronic device 200.

According to various embodiments, the electronic device 200 (e.g., the processor 371) may determine whether a charging connection has been established in operation 905. For example, when power is supplied from the connecting device 360 through a connection to the connecting device 360, the electronic device 200 (e.g., the power management module 381 of the processor 371) may obtain information indicating the charging connection from the charging circuit 350.

According to various embodiments, when determining that the charging connection has been established (operation 905-Yes), the electronic device 200 (e.g., the processor 371) may identify the state of the OS in operation 907, and perform at least one operation based on the identified state of the OS in operation 909. The electronic device 200 may identify an OS-related state, and when the identified OS-related state is the afore-described normal state (e.g., the first state), obtain battery-related information corresponding to the battery 340 from the always-on IC 320a. The electronic device 200 may provide the obtained battery - related information to programs (e.g., the OS program 403 and the application program 401).

According to various embodiments, when determining that the charging connection has not been established (operation 905-No), the electronic device 200 (e.g., the processor 371) may perform at least one charging operation related to the battery 340, using the charging circuit 350 in operation 911. For example, the at least one charging operation may include at least one of an operation of determining a charging mode (e.g., a charging start mode, a charging hold mode, or a charging stop mode), a charging start operation, a charging hold operation, a charging stop operation, or an operation of obtaining charging circuit-related information. For example, when determining that the charging connection has been established, the electronic device 200 (e.g., the power management module 381 of the processor 371) may determine a charging mode based on battery-related information and charging state information. In an embodiment, when the level of the battery 340 does not correspond to a fully charged level, and the current charging mode is the charging stop mode or the charging mode is not set, the electronic device 200 may identify (or determine or set) the charging mode as the charging start mode. When the charging mode is the charging start mode, the electronic device 200 may configure a charging-related parameter and charge the battery 340 based on power supplied from the connecting device 360, using the charging circuit. In another embodiment, when the level of the battery 340 does not correspond to the fully charged level, and the current charging mode is the charging start mode, the electronic device 200 may identify (or determine or set) the charging mode as the charging hold mode. When the charging mode is the charging hold mode, the electronic device 200 may continue charging the battery 340 using the charging circuit 350 by changing the charging-related parameter, identifying an error state related to charging, or identifying the charging circuit-related information (e.g., charging state-related information). The charging state-related information may include information about at least one of the current temperature of the battery 340, the level of the battery 340, or a time required to charge the battery 340. In another embodiment, when the level of the battery 340 corresponds to the fully charged level, the electronic device 200 may identify (or determine, or set) the current charging mode as the charging stop mode. When the charging mode is the charging stop mode, the electronic device 200 may stop charging the battery 340 using the charging circuit.

According to various embodiments, the electronic device 200 (e.g., the power management module 381 of the processor 371) may repeat the operation of identifying a charging mode and the operation of performing a charging operation based on the identified charging mode every specified period.

According to various embodiments, the electronic device 200 (e.g., the power management module 381 of the processor 371) may obtain the charging state-related information from the charging circuit every specified period during the at least one charging operation. For example, the charging circuit may transmit charging state-related information obtained while the charging mode is the charging start mode and/or the charging hold mode to the processor 371 every specified period. Accordingly, the power management module 381 of the processor 371 may obtain the charging state-related information every specified period.

An exemplary operation of the electronic device 200 according to various embodiments will be described below.

According to various embodiments, the afore-described second electronic component 320 (e.g., the always-on IC 320a) may obtain battery-related information from the battery 340. The second electronic component 320 may transmit a different type of information to the processor 371 according to the level of the battery 340 identified based on the obtained battery-related information.

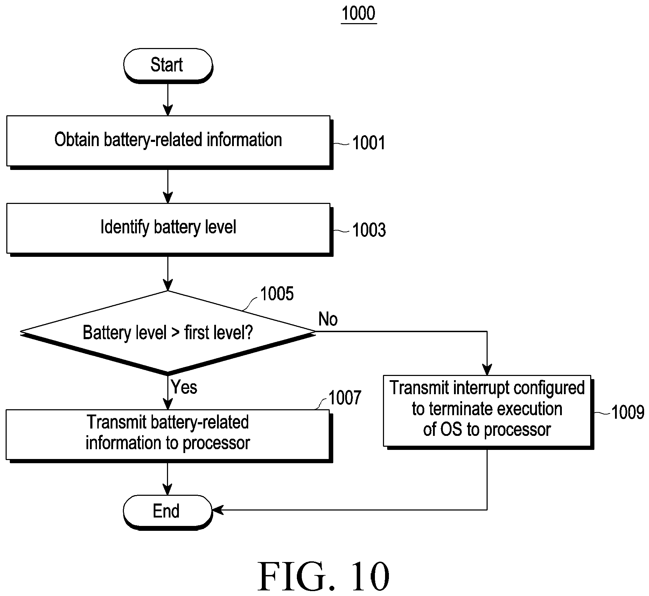

FIG. 10 is a flowchart 1000 illustrating an exemplary operation of the second electronic component 320 (e.g., the processor 371) according to various embodiments. According to various embodiments, the operations illustrated in FIG. 10 may be performed in various orders, not limited to the illustrated order. Further, according to various embodiments, more operations than those illustrated in FIG. 10 or at least one operation fewer than those illustrated in FIG. 10 may be performed.

According to various embodiments, the second electronic component 320 (e.g., the always-on IC 320a) may obtain battery-related information in operation 1001, and identify the level of the battery 340 in operation 1003. For example, the second electronic component 320 (e.g., the always-on IC 320a) may obtain the battery-related information from the electrically coupled battery 340 (e.g., a control circuit), and identify the level (or remaining capacity) of the battery 340 based on the battery-related information. As described above, the battery-related information may include information about at least one of the capacity of the battery 340, the current of the battery 340, the temperature of the battery 340, the level of the battery 340 (or the remaining capacity of the battery 340), a charging time of the battery 340, or the number of times the battery 340 has been charged and/or discharged. The battery 340 (e.g., the control circuit) may periodically identify battery-related information using the detection circuit, and transmit the identified battery-related information to the second electronic component 320 (e.g., the always-on IC 320a).

According to various embodiments, the second electronic component 320 (e.g., the always-on IC 320a) may determine whether the level of the battery 340 is higher than a first level in operation 1005. When the level is higher than the first level (operation 1005-Yes), the second electronic component 320 (e.g., the always-on IC 320a) may transmit the battery-related information to the processor 371 in operation 1007, and when the level of the battery 340 is equal to or lower than the first level (operation 1005-No), the second electronic component 320 (e.g., the always-on IC 320a) may transmit an interrupt configured to terminate execution of the OS to the processor 371 in operation 1009. For example, the first level may be a level of the battery 340 set to terminate the electronic device 200 and/or the OS.

In an embodiment, when the level of the battery 340 is higher than the first level, the second electronic component 320 (e.g., the always-on IC 320a) may provide the obtained battery-related information to the processor 371 coupled to the second electronic component 320 (e.g., the always-on IC 320a). Alternatively, upon receipt of an electrical signal by a user control (e.g., touch or pressing) for a device (e.g., the hardware device 330) coupled to the second electronic component 320, the second electronic component 320 (e.g., the always-on IC 320a) may transmit an interrupt for wake-up to the processor 371. When an OS-related state is an abnormal state (e.g., the afore-described second state), the processor 371 may change the OS-related state to a normal state (e.g., the afore-described first state) based on the interrupt.

In an embodiment, when the level of the battery 340 is equal to or lower than the first level, the second electronic component 320 (e.g., the always-on IC 320a) may transmit the interrupt configured to terminate the electronic device 200 to the processor 371. As described above, the processor 371 may terminate the OS and turn off the electronic device 200 based on the interrupt.

According to various embodiments, an electronic device (e.g., the electronic device 200 of FIG. 3) may include a battery (e.g., the battery 340 of FIG. 3), a charging circuit (e.g., the charging circuit 350 of FIG. 3) coupled to the battery (e.g., the battery 340 of FIG. 3), at least one first electronic component (e.g., the first electronic component 310 of FIG. 3) coupled to the charging circuit (e.g., the charging circuit 350 of FIG. 3), at least one second electronic component (e.g., the second electronic component 320 of FIG. 3) coupled to the charging circuit (e.g., the charging circuit 350 of FIG. 3) and the battery (e.g., the battery 340 of FIG. 3), and a chipset (e.g., the chipset 370 of FIG. 3) disposed separately from the at least one first electronic component (e.g., the first electronic component 310 of FIG. 3) and the at least one second electronic component (e.g., the second electronic component 320 of FIG. 3), coupled to the at least one first electronic component (e.g., the first electronic component 310 of FIG. 3) and the at least one second electronic component (e.g., the second electronic component 320 of FIG. 3), and including at least one processor (e.g., the processor 371 of FIG. 3). The at least one processor (e.g., the processor 371 of FIG. 3) may be configured to execute an OS, when an OS-related state is a first state, receive battery-related information from the at least one second electronic component (e.g., the second electronic component 320 of FIG. 3), and when the OS-related state is a second state, receive an interrupt configured to terminate the execution of the OS from the at least one second electronic component (e.g., the second electronic component 320 of FIG. 3).

According to various embodiments, the at least one processor (e.g., the processor 371 of FIG. 3) may be electrically coupled to the battery (e.g., the battery 340 of FIG. 3). The at least one processor (e.g., the processor 371 of FIG. 3) may be configured to receive the battery-related information from the at least one second electronic component (e.g., the second electronic component 320 of FIG. 3) among the at least one first electronic component (e.g., the first electronic component 310 of FIG. 3) and the at least one second electronic component (e.g., the second electronic component 320 of FIG. 3).

According to various embodiments, the electronic device (e.g., the electronic device 200 of FIG. 3) may further include an input device, and the at least one second electronic component (e.g., the second electronic component 320 of FIG. 3) may include an input device IC to control the input device.

According to various embodiments, while the OS-related state is the second state, the at least one first electronic component (e.g., the first electronic component 310 of FIG. 3) may be turned off, and the at least one second electronic component (e.g., the second electronic component 320 of FIG. 3) may be turned on.

According to various embodiments, the second state may include a deep sleep state.

According to various embodiments, the at least one processor (e.g., the processor 371 of FIG. 3) may be configured to, when the OS-related state is the second state, and a level of the battery (e.g., the battery 340 of FIG. 3) is higher than a specific level, receive the battery-related information from the at least one second electronic component (e.g., the second electronic component 320 of FIG. 3), and when the OS-related state is the second state, and the level of the battery (e.g., the battery 340 of FIG. 3) is equal to or lower than the specific level, receive the interrupt configured to terminate the execution of the OS from the at least one second electronic component (e.g., the second electronic component 320 of FIG. 3).

According to various embodiments, the electronic device (e.g., the electronic device 200 of FIG. 3) may further include an input device, and the at least one processor (e.g., the processor 371 of FIG. 3) may be configured to, when the OS-related state is the second state, and the level of the battery is higher than the specific level, receive a first interrupt configured to change the second state to the first state from the at least one second electronic component (e.g., the second electronic component 320 of FIG. 3) by control of the input device, and change the OS-related state from the second state to the first state based on the first interrupt.

According to various embodiments, the specific level may be a level set to terminate the OS.

According to various embodiments, the at least one processor (e.g., the processor 371 of FIG. 3) may be configured to, based on the execution of the OS, execute a first program to control the at least one second electronic component (e.g., the second electronic component 320 of FIG. 3), at least one second program supported by the OS, at least one third program being an application program, and a fourth program implemented to communicate with the first program, the at least one second program, and the at least one third program.

According to various embodiments, the at least one processor (e.g., the processor 371 of FIG. 3) may be configured to, based on the fourth program, obtain the battery-related information from the first program, and based on the fourth program, provide the battery-related information to at least some of the at least one second program and the at least one third program.

According to various embodiments, the at least one processor (e.g., the processor 371 of FIG. 3) may be configured to obtain the interrupt based on the first program, transmit the interrupt to the at least one second program based on the first program, and terminate the OS based on the at least one second program.

According to various embodiments, a method of operating an electronic device (e.g., the electronic device 200 of FIG. 3) may include executing an OS, when an OS-related state is a first state, receiving battery-related information from at least one second electronic component (e.g., the second electronic component 320 of FIG. 3) coupled to a charging circuit (e.g., the charging circuit 350 of FIG. 3) of the electronic device (e.g., the electronic device 200 of FIG. 3) and a battery (e.g., the battery 340 of FIG. 3) of the electronic device (e.g., the electronic device 200 of FIG. 3), and when the OS-related state is a second state, receiving an interrupt configured to terminate the execution of the OS from the at least one second electronic component (e.g., the second electronic component 320 of FIG. 3).

According to various embodiments, the method may include receiving the battery-related information from the at least one second electronic component (e.g., the second electronic component 320 of FIG. 3) among at least one first electronic component (e.g., the first electronic component 310 of FIG. 3) coupled to the charging circuit (e.g., the charging circuit 350 of FIG. 3) and the at least one second electronic component (e.g., the second electronic component 320 of FIG. 3), using at least one processor (e.g., the processor 371 of FIG. 3) coupled to the at least one second electronic component (e.g., the second electronic component 320 of FIG. 3).

According to various embodiments, the at least one second electronic component (e.g., the second electronic component 320 of FIG. 3) may include an input device IC to control an input device of the electronic device (e.g., the electronic device 200 of FIG. 3).

According to various embodiments, while the OS-related state is the second state, the at least one first electronic component (e.g., the first electronic component 310 of FIG. 3) may be turned off, and the at least one second electronic component (e.g., the second electronic component 320 of FIG. 3) may be turned on.

According to various embodiments, the second state may include a deep sleep state.

According to various embodiments, the method may include receiving the battery-related information from the at least one second electronic component (e.g., the second electronic component 320 of FIG. 3), and when the OS-related state is the second state, and the level of the battery (e.g., the battery 340 of FIG. 3) is equal to or lower than the specific level, receiving the interrupt configured to terminate the execution of the OS from the at least one second electronic component (e.g., the second electronic component 320 of FIG. 3)when the OS-related state is the second state, and a level of the battery (e.g., the battery 340 of FIG. 3) is higher than a specific level.

According to various embodiments, the method may include receiving a first interrupt configured to change the second state to the first state from the at least one second electronic component (e.g., the second electronic component 320 of FIG. 3) by control of an input device of the electronic device, and changing the OS-related state from the second state to the first state based on the first interrupt when the OS-related state is the second state, and the level of the battery is higher than the specific level.

According to various embodiments, the specific level may be a level set to terminate the OS.

According to various embodiments, an electronic device (e.g., the electronic device 200 of FIG. 3) may include a battery (e.g., the battery 340 of FIG. 3), a charging circuit (e.g., the charging circuit 350 of FIG. 3) coupled to the battery (e.g., the battery 340 of FIG. 3), at least one electronic component (or IC) coupled to the charging circuit (e.g., the charging circuit 350 of FIG. 3), an input device coupled to the charging circuit (e.g., the charging circuit 350 of FIG. 3) and the battery (e.g., the battery 340 of FIG. 3), and a chipset (e.g., the chipset 370 of FIG. 3) disposed separately from the at least one electronic component and the input device, coupled to the at least one electronic component and the input device, and including at least one processor (e.g., the processor 371 of FIG. 3). The input device may be configured to, when a level of the battery (e.g., the battery 340 of FIG. 3) is higher than a first level, transmit the battery-related information to the at least one processor (e.g., the processor 371 of FIG. 3), and when the level of the battery (e.g., the battery 340 of FIG. 3) is equal to or lower than the first level, transmit an interrupt configured to terminate the execution of the OS to the at least one processor (e.g., the processor 371 of FIG. 3).

## Claims

1. An electronic device comprising:
a battery;
a charging circuit coupled to the battery;
at least one first electronic component coupled to the charging circuit;
at least one second electronic component coupled to the charging circuit and the battery; and
a chipset disposed separately from the at least one first electronic component and the at least one second electronic component, coupled to the at least one first electronic component and the at least one second electronic component, and including at least one processor,
wherein the at least one processor is configured to:
execute an operating system,
when an operating system-related state is a first state, receive battery-related information from the at least one second electronic component, and
when the operating system-related state is a second state, receive an interrupt configured to terminate execution of the operating system from the at least one second electronic component.

2. The electronic device of claim 1, wherein the at least one processor is electrically coupled to the battery, and
wherein the at least one processor is further configured to:
receive the battery-related information from the at least one second electronic component among the at least one first electronic component and the at least one second electronic component.

3. The electronic device of claim 1, further comprising:
an input device, wherein the at least one second electronic component comprises an input device integrated circuit (IC) configured to control the input device.

4. The electronic device of claim 1, wherein while the operating system-related state is the second state, the at least one first electronic component is turned off and the at least one second electronic component is turned on.

5. The electronic device of claim 1, wherein the second state comprises a deep sleep state.

6. The electronic device of claim 1, wherein the at least one processor is further configured to:
when the operating system-related state is the second state, and a level of the battery is higher than a specific level, receive the battery-related information from the at least one second electronic component, and
when the operating system-related state is the second state, and the level of the battery is equal to or lower than the specific level, receive the interrupt configured to terminate the execution of the operating system from the at least one second electronic component.

7. The electronic device of claim 6, further comprising an input device,
wherein the at least one processor is further configured to:
when the operating system-related state is the second state, and the level of the battery is higher than the specific level, receive a first interrupt configured to change the second state to the first state from the at least one second electronic component by control of the input device, and
change the operating system-related state from the second state to the first state based on the first interrupt.

8. The electronic device of claim 7, wherein the specific level is a level set to terminate the operating system.

9. The electronic device of claim 1, wherein the at least one processor is further configured to:
execute a first program to control the at least one second electronic component,
execute at least one second program supported by the operating system,
execute at least one third program being an application program, and
execute a fourth program to communicate with the first program, the at least one second program, and the at least one third program.

10. The electronic device of claim 9, wherein the at least one processor is further configured to:
based on the execution of the fourth program, obtain the battery-related information from the first program, and
based on the execution of the fourth program, provide the battery-related information to at least one of the at least one second program and the at least one third program.

11. The electronic device of claim 9, wherein the at least one processor is further configured to:
obtain the interrupt based on the execution of the first program,
transmit the interrupt to the at least one second program based on the execution the first program, and
terminate the operating system based on the execution of the at least one second program.

12. A method of operating an electronic device, the method comprising:
executing an operating system;
when an operating system-related state is a first state, receiving battery-related information from at least one second electronic component coupled to a charging circuit of the electronic device and a battery of the electronic device; and
when the operating system-related state is a second state, receiving an interrupt configured to terminate the execution of the operating system from the at least one second electronic component.

13. The method of claim 12, further comprising:
receiving the battery-related information from the at least one second electronic component among at least one first electronic component coupled to the charging circuit and the at least one second electronic component, by using at least one processor coupled to the at least one second electronic component.

14. The method of claim 12, wherein the at least one second electronic component comprises an input device integrated circuit (IC) to control an input device of the electronic device.

15. The method of claim 13, wherein while the operating system-related state is the second state, the at least one first electronic component is turned off and the at least one second electronic component is turned on.
